# EUROPEAN PATENT SPECIFICATION

(11) **EP 4 191 690 B1**
(45) Date of publication and mention of the grant of the patent: **25.11.2026**
(21) Application number: 22207822.2
(22) Date of filing: 16.11.2022
(51) Int. Cl.: H10H 20/851, H10H 29/30, H10H 20/825, H10H 20/01

(54) **MICRO LIGHT EMITTING SEMICONDUCTOR DEVICE, DISPLAY APPARATUS INCLUDING THE SAME, AND METHOD OF MANUFACTURING THE SAME**
MIKROLICHTEMITTIERENDE HALBLEITERVORRICHTUNG, ANZEIGEVORRICHTUNG DAMIT UND VERFAHREN ZUR HERSTELLUNG DAVON
DISPOSITIF À SEMI-CONDUCTEUR MICRO-ÉMETTEUR DE LUMIÈRE, APPAREIL D'AFFICHAGE LE COMPRENANT ET SON PROCÉDÉ DE FABRICATION

(30) Priority: 01.12.2021 KR 20210170365
(43) Date of publication of application: 07.06.2023
(73) Proprietor: Samsung Electronics Co., Ltd., Gyeonggi-do 16677 (KR)
(72) Inventor: KIM, Dongho, Suwon-si (KR); HWANG, Kyungwook, Suwon-si (KR); PARK, Joonyong, Suwon-si (KR); HWANG, Junsik, Suwon-si (KR)
(74) Representative: Elkington and Fife LLP

(56) References cited:
- CN-B- 111 081 853
- US-A1- 2020 152 841
- US-A1- 2021 151 626
- US-B2- 11 142 684

## Description

### FIELD OF THE INVENTION

Example embodiments relate to a micro light emitting semiconductor device in which a color conversion layer and a micro light emitting chip have a single chip structure, a display apparatus including the micro light emitting semiconductor device, and a method of manufacturing the micro light emitting semiconductor device.

### BACKGROUND OF THE INVENTION

A liquid crystal display (LCD) and an organic light emitting diode (OLED) display have been widely used as display apparatuses. Recently, a technique for manufacturing a high-resolution display apparatus by using a micro light emitting device has been in the spotlight.

A display apparatus including a micro light emitting device requires many techniques, such as a transfer technique for moving a micro light emitting device to a pixel position of a desired display apparatus, a repair method, a method of realizing a desired color, etc.

US 2020/152841 A1 describes LED devices comprising gallium nitride LED diodes, at least a portion of which have been modified with quantum dots.

US 2021/151626 A1 describes a light source including an array of light emitters, with at least some light emitters having a central patterned surface.

US 11 142 684 B2 describes systems for hermetically sealed quantum dots that may be positioned directly on top of an LED, so that a separate film is not needed.

CN 111 081 853 B describes an LED component comprising an LED chip, wherein a light-transmitting quantum dot accommodating structure is arranged on one side surface of the LED chip.

### SUMMARY OF THE INVENTION

Example embodiments provide a micro light emitting semiconductor device in which a color conversion layer and a micro light emitting chip have a single chip structure.

Example embodiments also provide a display apparatus including a micro light emitting semiconductor device in which a color conversion layer and a micro light emitting chip have a single chip structure.

Example embodiments also provide a method of manufacturing a micro light emitting semiconductor device in which a color conversion layer and a micro light emitting chip have a single chip structure.

Additional aspects will be set forth in part in the description which follows and, in part, will be apparent from the description, or may be learned by practice of example embodiments.

According to an aspect of the invention, there is provided a micro light emitting semiconductor device including a first semiconductor layer, a light emitting layer provided on the first semiconductor layer, a second semiconductor layer provided on the light emitting layer, and a color conversion layer provided on the second semiconductor layer, the color conversion layer including a porous layer that includes quantum dots, wherein a doping type of the second semiconductor layer is different from a doping type of the color conversion layer.

The first semiconductor layer may include an n-type semiconductor, and the second semiconductor layer may include a p-type semiconductor.

The porous layer may include an n-GaN.

The first semiconductor layer, the light emitting layer, and the second semiconductor layer may be included in a micro light emitting chip, and the color conversion layer may be connected to the micro light emitting chip in a monolithic structure.

The micro light emitting semiconductor device may further include an interlayer provided between the second semiconductor layer and the color conversion layer.

The interlayer may include one of an oxide including at least one of SiO₂, LiNbO₃, and LiTaO₃, and a metal compound including at least one of Au:Ni, Au:Si, Al:Ge, Au:In, and Au:Sn.

The micro light emitting semiconductor device may further include a protective layer provided adjacent to the color conversion layer.

The protective layer may extend to the second semiconductor layer and the light emitting layer.

The micro light emitting semiconductor device of may further include a distributed Bragg reflective layer provided on the color conversion layer.

The micro light emitting semiconductor device may be a GaN based light emitting device.

According to an aspect of an example embodiment, there is provided a display apparatus including a substrate, partition walls provided on the substrate and spaced apart from each other, and micro light emitting semiconductor devices respectively provided in wells partitioned by the partition walls, wherein each of the micro light emitting semiconductor devices includes**,** in accordance with the invention, a first semiconductor layer, a light emitting layer provided on the first semiconductor layer, a second semiconductor layer provided on the light emitting layer, and a color conversion layer provided on the second semiconductor layer, the color conversion layer including a porous layer that includes quantum dots, wherein a doping type of the second semiconductor layer is different from a doping type of the color conversion layer.

The first semiconductor layer may include an n-type semiconductor, and the second semiconductor layer may include a p-type semiconductor.

The porous layer may include an n-GaN layer.

The first semiconductor layer, the light emitting layer, and the second semiconductor layer may be included in a micro light emitting chip, and the color conversion layer may be connected to the micro light emitting chip in a monolithic structure.

The display apparatus may further include an interlayer provided between the second semiconductor layer and the color conversion layer.

The interlayer may include one of an oxide including at least one of SiO₂, LiNbO₃, and LiTaO₃, and a metal compound including at least one of Au:Ni, Au:Si, Al:Ge, Au:In, and Au:Sn.

The display apparatus may further include a protective layer provided adjacent to the color conversion layer.

The protective layer may extend to the second semiconductor layer and the light emitting layer.

The display apparatus may further include a distributed Bragg reflective layer provided on the color conversion layer.

According to another aspect of the invention, there is provided a method of manufacturing a micro light emitting semiconductor device, the method including forming a first semiconductor layer on a first substrate, forming a light emitting layer on the first semiconductor layer, forming a second semiconductor layer on the light emitting layer, stacking a u-GaN layer and an n-GaN layer on a second substrate, bonding the n-GaN layer to the second semiconductor layer, separating the u-GaN layer from the n-GaN layer, forming a porous layer by etching the n-GaN layer through electrochemical etching, forming a color conversion layer by immersing the porous layer in a quantum dot liquid to infiltrate quantum dots into the porous layer, and separating a structure formed by the above operations in units of microchips.

The method may further include a two-dimensional material layer provided between the u-GaN layer and the n-GaN layer.

The two-dimensional material layer may include at least one of graphene, BN, MoS₂, WSe₂, CrO₂, CrS₂, VO₂, VS₂, and NbSe₂.

The method may further include after stacking the u-GaN layer and the n-GaN layer on the second substrate, forming a temporary substrate on the n-GaN layer, separating the second substrate from the u-GaN layer, and separating the u-GaN layer from the n-GaN layer.

The first semiconductor layer, the light emitting layer, and the second semiconductor layer may be included in a micro light emitting chip, and the color conversion layer may be connected to the micro light emitting chip in a monolithic structure.

The method may further include forming an interlayer between the second semiconductor layer and the color conversion layer.

The interlayer may include one of an oxide including at least one of SiO₂, LiNbO₃, and LiTaO₃, and a metal compound may include at least one of Au:Ni, Au:Si, Al:Ge, Au:In, and Au:Sn.

The method may further include forming a protective layer adjacent to the color conversion layer.

The protective layer may extend to the second semiconductor layer and the light emitting layer.

The method may further include forming a distributed Bragg reflective layer on the color conversion layer.

### BRIEF DESCRIPTION OF THE DRAWINGS

The above and/or other aspects, features, and advantages of example embodiments will be more apparent from the following description taken in conjunction with the accompanying drawings, in which:
FIG. 1 is a cross-sectional view of a micro light emitting semiconductor device according to the invention;
FIG. 2 illustrates an example in which an interlayer is further included in the micro light emitting semiconductor device of FIG. 1;
FIG. 3 is a cross-sectional view of a display apparatus according to the invention;
FIGS. 4, 5, 6, 7, 8, 9, 10, 11, 12, 13, 14, and 15 are views illustrating a method of manufacturing a micro light emitting semiconductor device, according to the invention;
FIG. 16 is a view illustrating a method of transferring a micro light emitting semiconductor device onto a substrate;
FIGS. 17, 18, 19, 20, 21, 22, and 23 are views illustrating a method of manufacturing a micro light emitting semiconductor device, according to another example embodiment not forming part of the invention as claimed;
FIG. 24 is a schematic block diagram of an electronic apparatus according to an example embodiment;
Fig. 25 illustrates an example in which a display apparatus according to an example embodiment is applied to a mobile device;
FIG. 26 illustrates an example in which a display apparatus according to an example embodiment is applied to a vehicle display apparatus;
FIG. 27 illustrates an example in which a display apparatus according to an example embodiment is applied to augmented reality glasses;
FIG. 28 illustrates an example in which a display apparatus according to an example embodiment is applied to a signage; and
FIG. 29 illustrates an example in which a display apparatus according to an example embodiment is applied to a wearable display.

### DETAILED DESCRIPTION

Reference will now be made in detail to embodiments, examples of which are illustrated in the accompanying drawings, wherein like reference numerals refer to like elements throughout. In this regard, example embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, a micro light emitting semiconductor device, a display apparatus including the micro light emitting semiconductor device, and a method of manufacturing the micro light emitting semiconductor device according to various embodiments will be described in detail with reference to the accompanying drawings. In the drawings, like reference numerals refer to like elements, and a size of each element in the drawings may be exaggerated for clarity and convenience of description. The terms "first", "second", and so on may be used to describe various configuration elements but configuration elements should not be limited by the terms. Terms are only used for the purpose of distinguishing one configuration element from another configuration element.

A singular expression includes plural expressions unless the context clearly indicates otherwise. In addition, when a part is described to "include" a certain configuration element, which means that the part may further include other configuration elements, except to exclude other configuration elements unless otherwise stated. In addition, in the drawings, a size or a thickness of each configuration element may be exaggerated for the sake of clear description. In addition, when it is described that a certain material layer is formed on a substrate or another layer, the material layer may also be formed in direct contact with the substrate or another layer, or a third layer may be formed therebetween. In addition, in the following examples, materials forming respective layers are examples, and other materials may be used.

In addition, terms such as "unit", "portion", and "module" described in the specification may indicate units that process at least one function or operation, which may be configured by hardware, software, or a combination of hardware and software..

Specific implementations described in the present embodiment are examples and do not limit the technical scope in any way. For the sake of brief specification, descriptions of electronic configurations of the related art, control systems, software, and other functional aspects of the systems may be omitted. In addition, connection or connection members of lines between configuration elements illustrated in the drawings exemplarily represent functional connections and/or physical or circuit connections and may be represented as alternative or additional various functional connections, physical connections, or circuit connections in an actual apparatus.

Use of a term "above-described" and a similar reference term may correspond to both the singular and the plural.

Steps constituting a method are not limited in the order described and may be performed in any suitable order unless there is a clear statement that the steps should be performed in the order described. In addition, use of all example terms ("for example" and "and so on") is merely for describing technical ideas in detail, and the scope of the claims are not limited to the terms unless limited by claims.

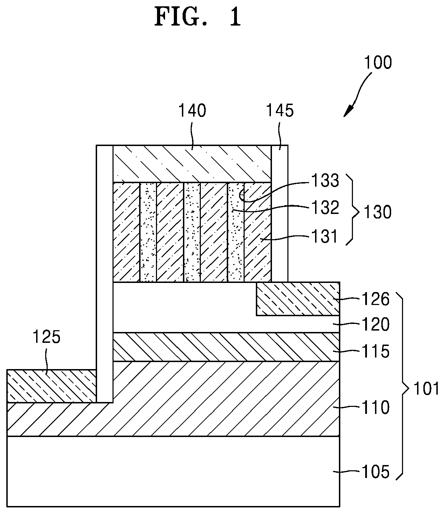

FIG. 1 illustrates a micro light emitting semiconductor device according to the invention.

A micro light emitting semiconductor device 100 includes a first semiconductor layer 110, a light emitting layer 115 provided on the first semiconductor layer 110, a second semiconductor layer 120 provided on the light emitting layer 115, and a color conversion layer 130 provided on the second semiconductor layer 120. The first semiconductor layer 110, the light emitting layer 115, and the second semiconductor layer 120 may constitute a micro light emitting chip 101. In addition, the second semiconductor layer 120 and the color conversion layer 130 include, in accordance with the invention, semiconductor layers of different doping types. The micro light emitting semiconductor device 100 may be a GaN based light emitting device

The first semiconductor layer 110 may include a first type semiconductor. For example, the first semiconductor layer 110 may include an n-type semiconductor. The first semiconductor layer 110 may include an n-type group III-V semiconductor, for example, n-GaN. The first semiconductor layer 110 may have a single layer structure or a multi-layer structure.

The light emitting layer 115 is provided on an upper surface of the first semiconductor layer 110. Electrons combine with holes to generate light in the light emitting layer 115. The light emitting layer 115 may have a multi-quantum well (MQW) or a single-quantum well (SQW) structure. The light emitting layer 115 may include a group III-V semiconductor, for example, gallium nitride (GaN).

The second semiconductor layer 120 is provided on an upper surface of the light emitting layer 115. The second semiconductor layer 120 may include, for example, a p-type semiconductor. The second semiconductor layer 120 may include a p-type group III-V semiconductor, for example, p-GaN. The second semiconductor layer 120 may have a single layer structure or a multi-layer structure.

A u-GaN layer 105 may be further provided beneath the first semiconductor layer 110. The u-GaN layer 105 may be used as a buffer layer for growing the first semiconductor layer 110. The micro light emitting chip 101 may have a horizontal electrode structure. A first electrode 125 may be provided on a part of the upper surface of the first semiconductor layer 110, and a second electrode 126 may be provided on a part of the upper surface of the second semiconductor layer 120. However, positions of the first electrode 125 and the second electrode 126 are not limited thereto. The first electrode 125 and the second electrode 126 may each include, for example, silver (Ag), gold (Au), aluminum (Al), chromium (Cr), nickel (Ni), or an alloy thereof. However, the first electrode 125 and the second electrode 126 are not limited thereto.

The color conversion layer 130 may have a structure in which quantum dots 132 for color conversion are embedded in a porous layer 131 including holes 133. The porous layer 131 may include n-GaN. The porous layer 131 may be formed by etching N-GaN through an electrochemical etching method. When the porous layer 131 is immersed in quantum dot liquid, the quantum dots 132 may be embedded into the porous layer 131. When the quantum dots 132 are embedded in the porous layer 131, a light scattering effect of the light incident on the color conversion layer 130 may be increased to increase color conversion efficiency. When the color conversion efficiency is increased, a thickness of the color conversion layer 130 may be reduced to be relatively thin, and leakage of blue light that is not color-converted may be reduced, and thus, a high-purity color may be obtained.

The quantum dots 132 may each be formed of an inorganic material having a size of several nm and have an energy bandgap of a specified wavelength to emit light of different wavelengths when absorbing light of energy higher than the energy bandgap. The quantum dots 132 each have a narrow light emission wavelength band such that color reproducibility of a display may be increased.

The quantum dots 132 may each include a group II-VI semiconductor, a group III-V semiconductor, a group IV-VI semiconductor, a group IV semiconductor, and/or graphene quantum dots. The quantum dots 132 may each include, for example, cadmium (Cd), selenium (Se), zinc (Zn), sulfur (S), and/or indium phosphide (InP) and may each have a diameter of several tens of nm or less, for example, a diameter of about 10 nm or less. The quantum dots 132 may be excited by blue light to emit green light or red light, depending on their material or size. According to another example embodiment, the quantum dots 132 may be excited by extreme ultraviolet light to emit blue light, green light, or red light.

A protective layer 145 may be provided adjacent to and to surround the color conversion layer 130. The protective layer 145 may extend from a side surface of the color conversion layer 130 to at least a part of side surfaces of the first semiconductor layer 120 and the light emitting layer 115. According to another example embodiment, the protective layer 145 may extend from a side surface of the color conversion layer 130 to a partial side surface of the second semiconductor layer 110. Because the quantum dots 132 are vulnerable to moisture, the protective layer 145 is provided on the color conversion layer 130 to increase reliability of the color conversion layer 130 and to reduce consumption of the quantum dots 132, and thus, price competitiveness of the micro light emitting semiconductor device 100 may be increased. The protective layer 145 may include, for example, aluminum oxide (AL₂O₃), silicon oxide (SiO₂), or silicon nitride (SiN).

Green and red micro light emitting devices of a display apparatus have lower luminous efficiency and a lower price than a blue micro light emitting device. Accordingly, a color image may be displayed by converting blue light into green light or red light by using the color conversion layer 130, and thus, it is possible to increase luminous efficiency and reduce manufacturing cost.

A distributed Bragg reflective layer 140 may be further provided on the color conversion layer 130. The distributed Bragg reflective layer 140 has a structure in which two layers with different refractive indices are alternately stacked and may reflect light of a specified color, for example, light in a wavelength range of about 300 nm to about 500 nm. The distributed Bragg reflective layer 140 reflects blue light or extreme ultraviolet light that is not converted by the color conversion layer 130 to the color conversion layer 130 to be recycled for color conversion by the color conversion layer 130, and thus, a color conversion rate may be increased.

The micro light emitting semiconductor device 100 may have a size of, for example, about 200 µm or less. According to another example embodiment, the micro light emitting semiconductor device 100 may have a size of, for example, about 100 µm or less. In addition, the micro light emitting chip 101 and the color conversion layer 130 may be formed monolithically and integrally in a chip unit, and thus, a manufacturing process may be relatively simplified and manufacturing cost may be relatively reduced compared to a case of separately forming a color conversion layer.

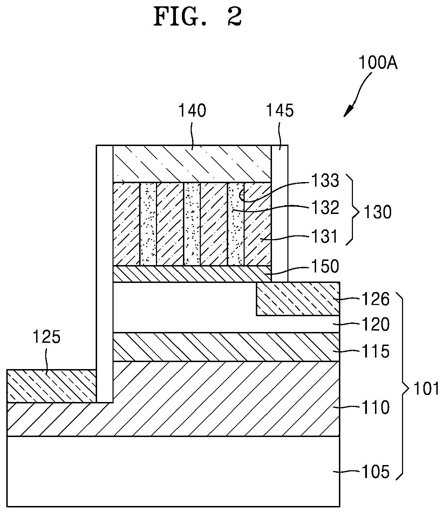

FIG. 2 illustrates an example in which an interlayer is further provided in the micro light emitting semiconductor device illustrated in FIG. 1. Components given the same reference numerals as in FIG. 1 have substantially the same configuration and function, and thus, detailed descriptions thereof are omitted.

A micro light emitting semiconductor device 100A may further include an interlayer 150 provided between the micro light emitting chip 101 and the color conversion layer 130. The interlayer 150 may be provided between the second semiconductor layer 120 and the color conversion layer 130. The interlayer 150 may be formed of an oxide including at least one of SiO₂, lithium niobate (LiNbO₃), and lithium tantalum oxide (LiTaO₃), or a metal compound including at least one of Au:Ni, Au:Si, aluminum: germanium (Al:Ge), Au:In, and aluminum:tin (Au:Sn). The interlayer 150 may increase a bonding force between the micro light emitting chip 101 and the color conversion layer 130. In addition, when the quantum dots 132 are arranged close to the micro light emitting chip 101, a color conversion rate may be reduced due to instability. When the quantum dots 132 are exposed to strong light or subjected to thermal shock, properties thereof tend to be rapidly reduced. Accordingly, efficiency may be increased when the quantum dots 132 are separated from the micro light emitting chip 101 by a preset distance. The interlayer 150 may have a thickness of, for example, about 50 nm to about 2 µm. The interlayer 150 may separate the color conversion layer 130 from the micro light emitting chip 101 and prevent characteristics of the color conversion layer 130 from being reduced due to light from the micro light emitting chip 101.

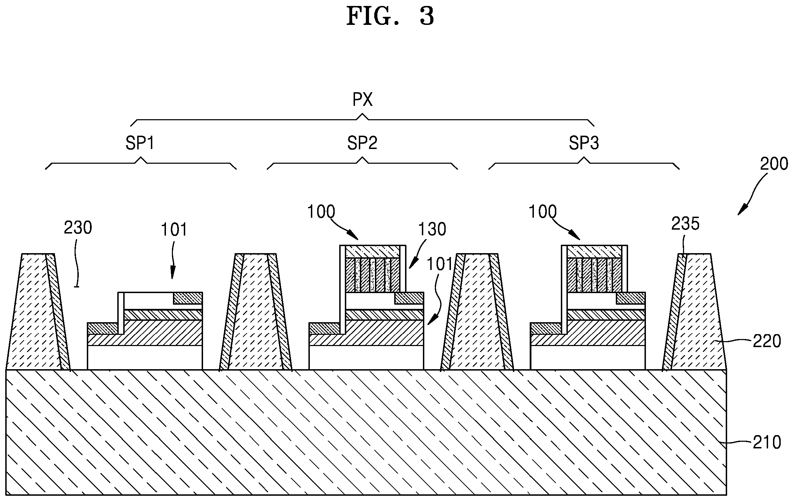

FIG. 3 schematically illustrates a display apparatus according to an example embodiment.

Referring to FIG. 3, a display apparatus 200 may include a plurality of pixels PX, and the plurality of pixels PX may each include sub-pixels emitting different colors. The pixel PX may be a unit for displaying an image. An image may be displayed by controlling color and the amount of light of the respective sub-pixels. For example, the pixel PX may include a first sub-pixel SP1, a second sub-pixel SP2, and a third sub-pixel SP3.

The display apparatus 200 may include a substrate 210, partition walls 220 provided on the substrate 210, and micro light emitting semiconductor devices 100 respectively provided in wells 230 partitioned by the partition walls 220. FIG. 3 illustrates an example in which the substrate 210 and the partition walls 220 are configured as separate bodies is illustrated, however, embodiments are not limited thereto, and the substrate 210 and the partition walls 220 may be configured as a single body. The substrate 210 may be formed of a backplane substrate including drivers for driving the micro light emitting semiconductor devices 100 or a transfer mold substrate for transferring the micro light emitting semiconductor devices 100 to another substrate.

The micro light emitting semiconductor devices 100 may be respectively provided in the wells 230. The micro light emitting semiconductor devices 100 may respectively include the micro light emitting chips 101 and the color conversion layers 130, which are the same as described with reference to FIGS. 1 and 2, and thus, detailed descriptions thereof are omitted. In addition, the micro light emitting chips 101 may be provided in other wells 230. The micro light emitting semiconductor devices 100 and the micro light emitting chips 101 may be transferred onto the substrate 210. A method for the transfer may include a stamp method, a pick and place method, or a fluidic self-assembly method.

Blue light may be emitted from the micro light emitting chip 101 of the first sub-pixel SP1. The quantum dots 132 of the color conversion layer 130 may be excited by blue light emitted from the micro light emitting chip 101, and thus, the second sub-pixel SP2 may emit green light. The quantum dots 132 of the color conversion layer 130 may be excited by the blue light emitted from the micro light emitting chip 101, and thus, the third sub-pixel SP3 may emit red light. The emitted color band may vary depending on materials or sizes of the quantum dots 132.

The micro light emitting semiconductor devices 100 have a monolithic structure and are respectively provided in the wells 230, and thus, there may be separation spaces between the color conversion layers 130 of the micro light emitting semiconductor devices 100 and the partition walls 220.

A reflective layer 235 may be further provided on the partition wall 220 of the well 230. The reflective layer 235 may reflect light emitted from the micro light emitting semiconductor device 100 to become effective light.

Next, a method of manufacturing a micro light emitting semiconductor device according to the invention will be described.

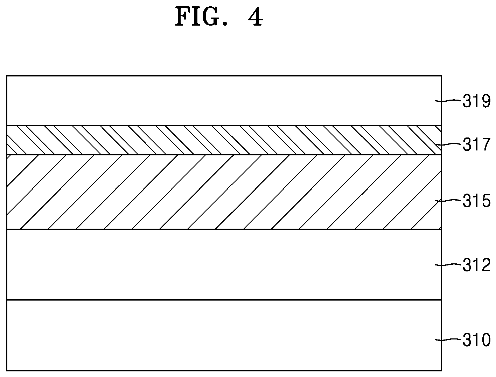

Referring to FIG. 4, a first semiconductor layer 315 is formed on a first substrate 310, and a light emitting layer 317 is formed on the first semiconductor layer 315. In addition, a second semiconductor layer 319 is formed on the light emitting layer 317. The first substrate 310 may include, for example, a silicon substrate, a sapphire substrate, or a glass substrate. However, the first substrate 310 is not limited thereto, and various epitaxial substrates may be used therefor. The first semiconductor layer 315 may include, for example, an n-type semiconductor layer. The first semiconductor layer 315 may include an n-GaN layer. The second semiconductor layer 319 may include a p-type semiconductor layer. A u-GaN layer 312 may be formed between the first substrate 310 and the first semiconductor layer 315.

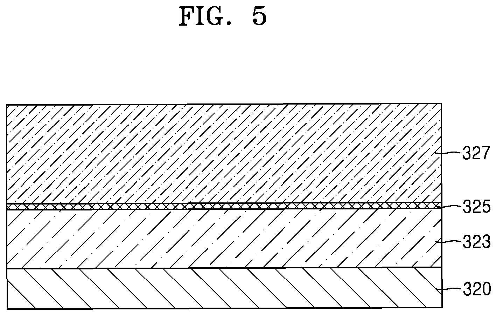

Referring to FIG. 5, a u-GaN layer 323 and an n-GaN layer 327 is bonded on a second substrate 320. The second substrate 320 may include, for example, a silicon substrate or a sapphire substrate. A two-dimensional material layer 325 may be formed between the u-GaN layer 323 and the n-GaN layer 327. The two-dimensional material layer 325 may include at least one of graphene, boron nitride (BN), molybdenum disulfide (MoS₂), tungsten diselenide (WSe₂), chromium oxide (CrO₂), chromium sulfide (CrS₂), vanadium dioxide (VO₂), vanadium disulfide (VS₂), and niobium selenide (NbSe₂). As described below, the two-dimensional material layer 325 may more easily separate the n-GaN layer 327 from the u-GaN layer 323. When the n-GaN layer 327 grows on the second substrate 320, the n-GaN layer 327 may grow along a lattice of the second substrate 320 instead of a lattice of the two-dimensional material layer 325.

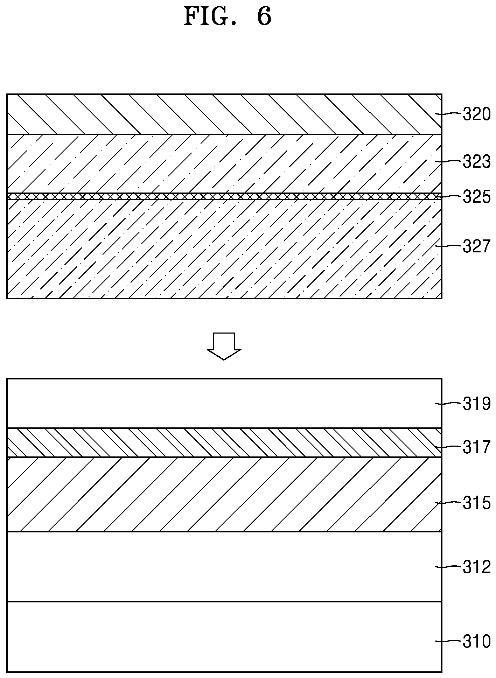

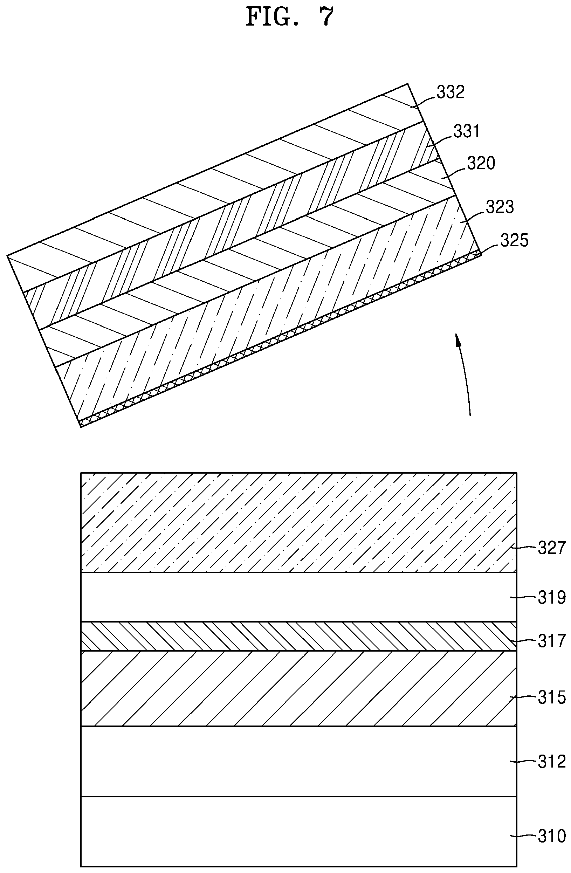

Referring to FIG. 6, the structure illustrated in FIG. 5 is combined with the light emitting structure illustrated in FIG. 4. In this case, the two structures may be combined by making the n-GaN layer 327 face the second semiconductor layer 319. In addition, referring to FIG. 7, the u-GaN layer 323 is separated from the n-GaN layer 327. Because the two-dimensional material layer 325 has a weak adhesive force, the u-GaN layer 323 may be more easily separated from the n-GaN layer 327.

Before the u-GaN layer 323 is separated from the n-GaN layer 327, at least one metal layer may be stacked on the second substrate 320. For example, a Ti layer 331 and a Ni layer 332 may be stacked on the second substrate 320. Then, the two-dimensional material layer 325 having a weak bonding force may be more easily separated due to stress applied by the Ti layer 331 and the Ni layer 332. Accordingly, the n-GaN layer 327 may be exposed.

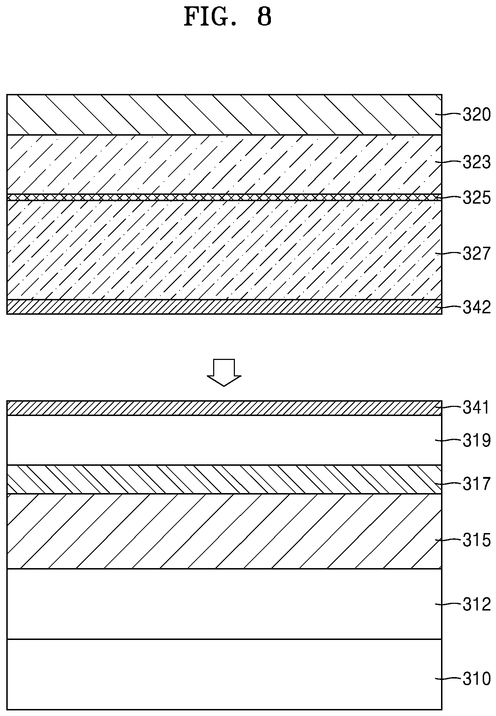

Referring to FIG. 8, a first interlayer 341 may be further stacked on the second semiconductor layer 319 of the structure illustrated in FIG. 6, and a second interlayer 342 may be further stacked on the n-GaN layer 327. The first interlayer 341 and the second interlayer 342 may each include, for example, an oxide including at least one of SiO₂, LiNbO₃, and LiTaO₃, or a metal compound including at least one of Au:Ni, Au:Si, Al:Ge, Au:In, and Au:Sn. In addition, wafer bonding may be performed through the first interlayer 341 and the second interlayer 342.

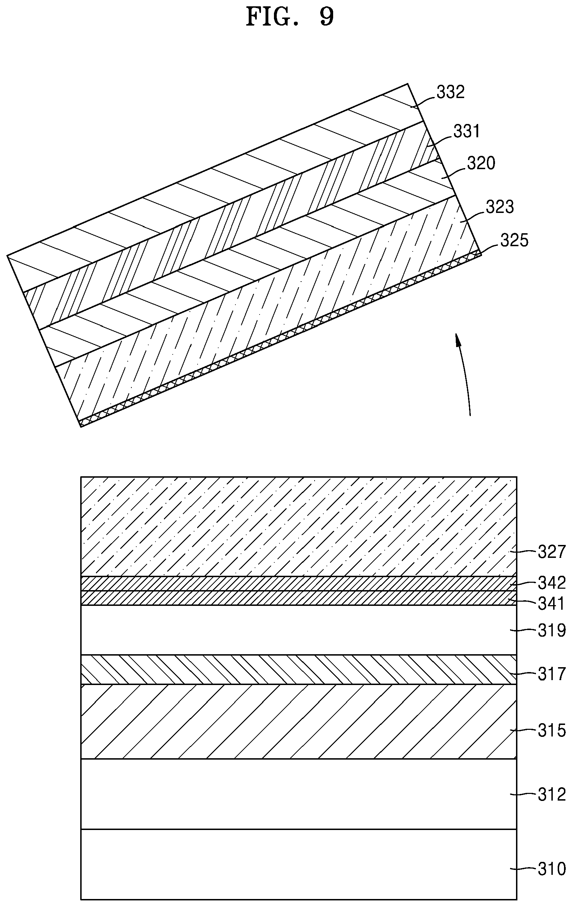

Then, referring to FIG. 9, the u-GaN layer 323 and the second substrate 320 may be separated from the n-GaN layer 327 to expose the n-GaN layer 327.

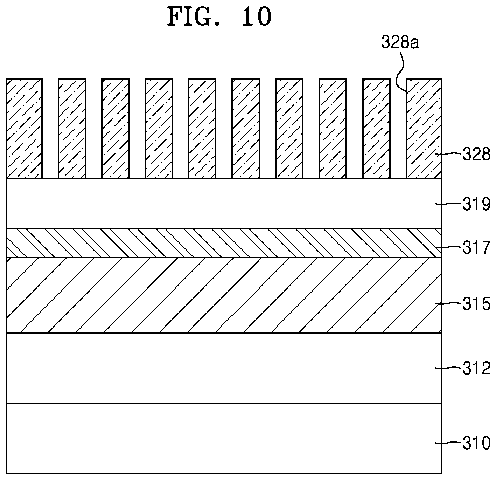

In FIG. 10, a porous layer 328 is formed by etching the n-GaN layer 327 of the structure illustrated in FIG. 7 by using an electrochemical etching method. The porous layer 327 may include a plurality of holes 328a. In the electrochemical etching method, a sample to be etched is immersed in a solvent, and an electrode is connected to the sample and the solvent to generate carriers by using an external bias, and thus, etching may be performed. The solvent used at this time may include various solvents such as oxalic acid. In the electrochemical etching method, the electrode may be directly connected to the sample, or the electrode may also be indirectly connected by using two chambers.

When a voltage is applied to the sample, selective etching is performed on the sample under specified conditions, and the sample may be transformed into a porous layer. An etchant may include at least one of, for example, potassium hydroxide (KOH), sodium hydroxide (NaOH), hydrogen chloride (HCl), oxalic axid (C₂H₂O₄), sulfuric acid (H₂SO₄), nitric acid (HNO₃), and hydrogen fluoride (HF).

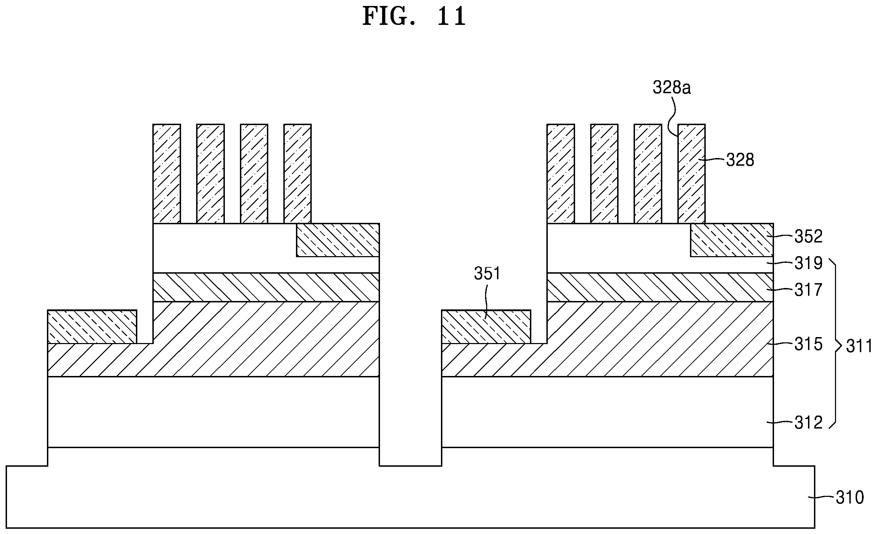

Referring to FIG. 11, the structure illustrated in FIG. 10 may be etched in units of microchips, a first electrode 351 may be formed on the first semiconductor layer 315, and a second electrode 352 may be formed on the second semiconductor layer 319. In an etching step, etching may be performed to only a partial depth of the first substrate 310. For example, in the etching step, the first substrate 310 may be a wafer unit structure. The first electrode 351 and the second electrode 352 may be formed in a wafer structure. The wafer structure may be etched in units of microchips to form the micro light emitting chip 311 including the first semiconductor layer 315, the light emitting layer 317, and the second semiconductor layer 319.

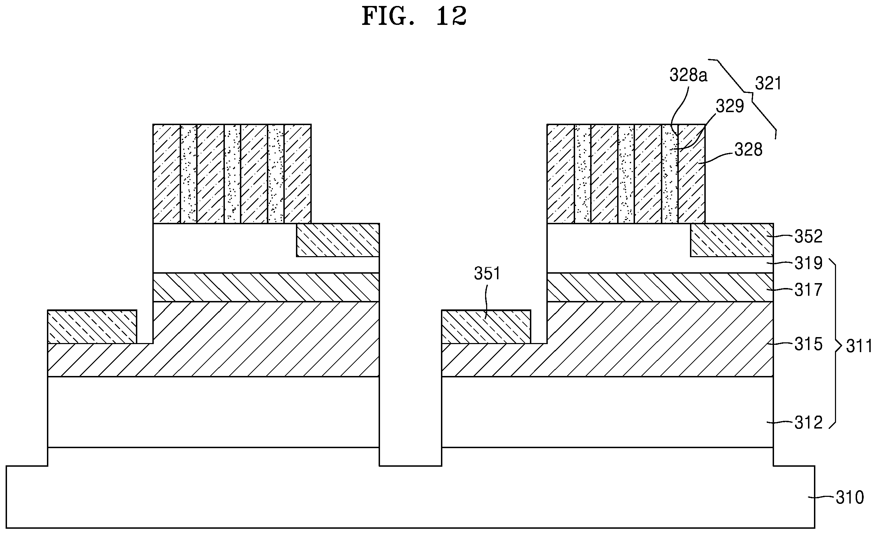

Referring to FIG. 12, a color conversion layer 321 is formed by immersing the porous layer 328 in a quantum dot liquid to infiltrate quantum dots 329 into holes 328a of the porous layer 328.

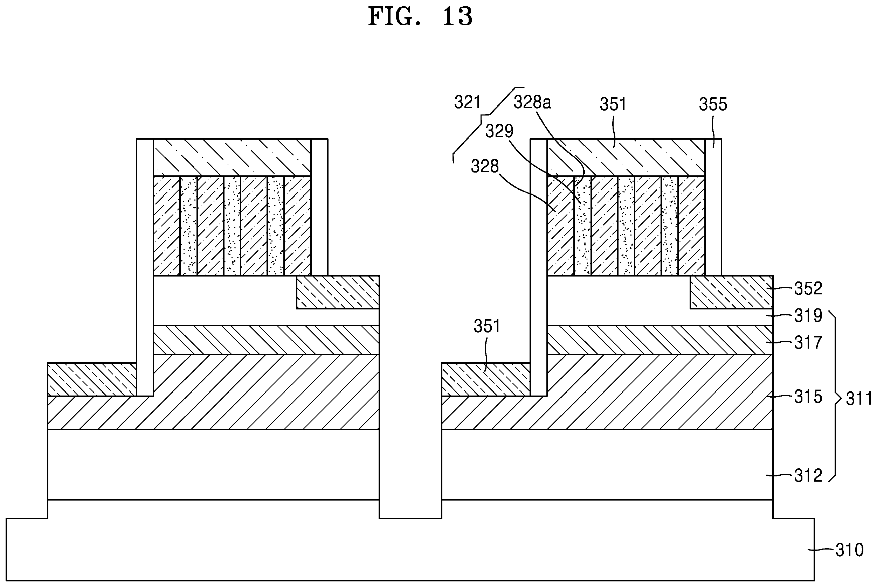

Referring to FIG. 13, a distributed Bragg reflective layer 351 may be formed on the color conversion layer 321. In addition, a protective layer 355 may be formed on the side surface of the color conversion layer 321. The protective layer 355 may prevent characteristics of the color conversion layer 321 from being reduced by an external environment. The protective layer 355 may include, for example, Al₂O₃, SiO₂, or SiN. The protective layer 355 may extend to the second semiconductor layer 319 and the light emitting layer 317. According to another example embodiment, the protective layer 355 may extend to a part of the second semiconductor layer 319, a part of the light emitting layer 317, and a part of the first semiconductor layer 315.

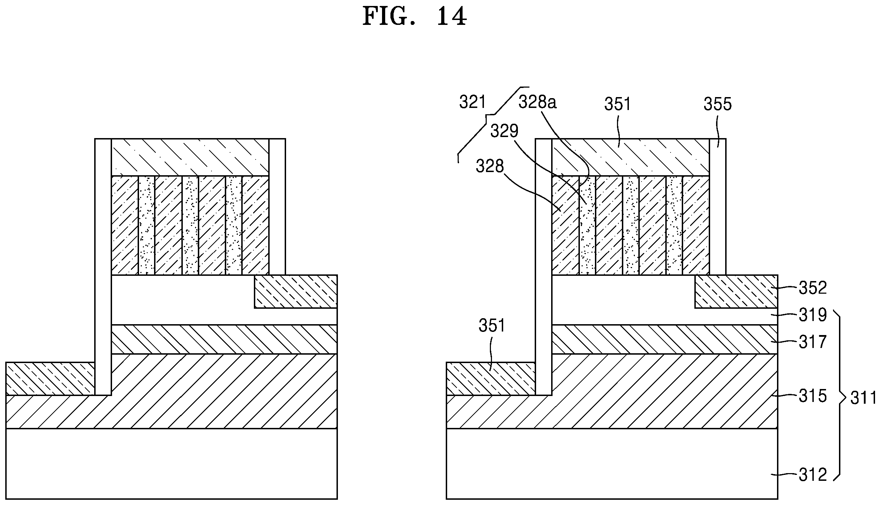

Referring to FIG. 14, micro light emitting semiconductor devices may be formed in units of microchips by removing the first substrate 310. Therefore, the micro light emitting chip 311 and the color conversion layer 321 may be formed in a monolithic structure. A chemical lift-off method may be used to remove the first substrate 310. For example, when the first substrate 310 is removed by performing wet etching with KOH, the u-GaN layer 312 or the n-GaN layer 315 may be smoothly separated from the first substrate 310 because of a large etch rate difference with the first substrate 310. Accordingly, the u-GaN layer 312 or the n-GaN layer 315 may have a smooth surface. In addition, the color conversion layer 321 may have a relatively rough surface because the color conversion layer 321 is composed of the porous layer 328. Accordingly, an upper surface (an upper surface of a color conversion layer) of a micro light emitting semiconductor device may have a relatively large roughness compared to a lower surface thereof (a lower surface of the u-GaN layer 312 or the n-GaN layer 315). For example, the upper surface (the upper surface of the color conversion layer) of the micro light emitting semiconductor device may have a relatively large surface energy compared to the lower surface thereof (the lower surface of the u-GaN layer 312 or the n-GaN layer 315).

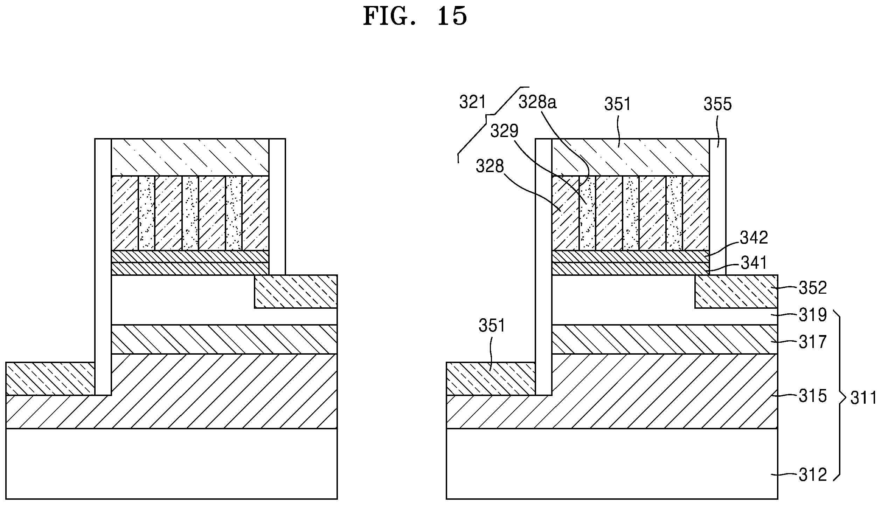

FIG. 15 illustrates a micro light emitting semiconductor device formed from the structure illustrated in FIG. 9. The first interlayer 341 and the second interlayer 342 may be provided between the micro light emitting chip 311 and the color conversion layer 321.

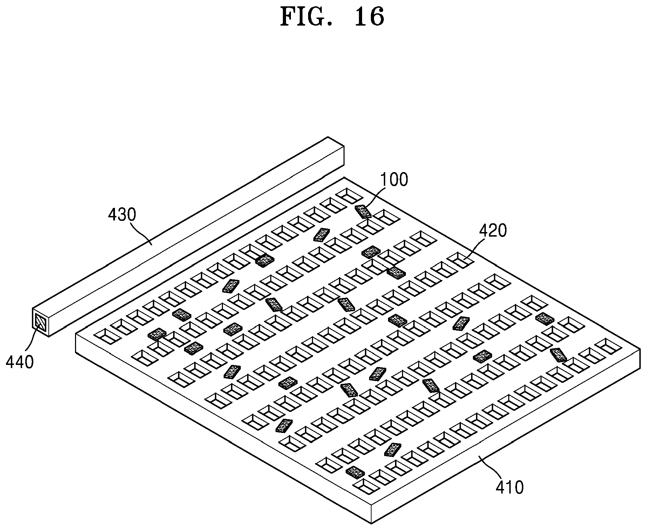

Next, an example of a method of transferring a micro light emitting semiconductor device will be described. FIG. 16 is a view illustrating a method of transferring a micro light emitting semiconductor chip by using a wet self-assembly transfer method, according to an example embodiment.

A substrate 410 including a plurality of wells 420 is prepared. The substrate 410 may include a single layer or may include a plurality of layers. The micro light emitting semiconductor device 100 is arranged in the well 420. The micro light emitting semiconductor device 100 may include various types of semiconductor chips having a micro size, and the micro size may be about 200 µm or less. According to another example embodiment, the micro size may be about 100 µm or less. In addition, a liquid may be supplied to the well 420. Any kind of liquid may be used as the liquid as long as the liquid does not corrode or damage the micro semiconductor light emitting device 100. The liquid may include one or a compound of, for example, water, ethanol, alcohol, polyol, ketone, halocarbon, acetone, flux, and an organic solvent. The organic solvent may include, for example, isopropyl alcohol (IPA). However, a usable liquid is not limited thereto, and various modifications may be made.

A method of supplying a liquid to the well 420 may include, for example, a spray method, a dispensing method, an inkjet dot method, a method of flowing a liquid to the substrate 410, and so on. A plurality of micro light emitting semiconductor devices 100 are supplied to the substrate 410. The plurality of micro light emitting semiconductor devices 100 may be directly sprayed onto the substrate 410 without any other liquid or may be supplied thereto by being included in a suspension. A method of supplying the micro light emitting semiconductor devices 100 included in the suspension may include a spray method, a dispensing method of dropping a liquid, an inkjet dot method of ejecting a liquid like a printing method, a method of flowing the suspension onto the substrate 410, and so on.

The substrate 410 is scanned by an absorber 430 capable of absorbing a liquid. Any material may be used for the absorber 430 as long as the material may absorb a liquid, and a shape or a structure thereof is not limited. The absorber 430 may include, for example, fabric, tissue, polyester fiber, paper, a wiper, etc. The absorber 430 may be used alone without other auxiliary devices, but the absorber 430 is not limited thereto and may be coupled to a support 440 to conveniently scan the substrate 410. The support 440 may have various shapes and structures suitable for scanning the substrate 410. The support 440 may have a form of, for example, a rod, a blade, a plate, or a wiper. The absorber430 may be provided on either side of the support 440 or may surround the support 440.

The absorber 430 may scan the substrate 410 while pressing the substrate 410 with an appropriate pressure. Scanning may include a step of absorbing a liquid while the absorber 430 passes through the plurality of wells 420 while in contact with the substrate 410. The scanning may be performed in various ways such as a sliding method, a rotating method, a translating motion method, a reciprocating motion method, a rolling method, a spinning method, and/or a rubbing method of the absorber 430 and may include both a regular method and an irregular method. The scanning may also be performed by moving the substrate 410 instead of the absorber 430 and may be performed in various ways such as a sliding method, a rotating method, a translating motion method, a reciprocating motion method, a rolling method, a spinning method, and/or a rubbing method of the substrate 410. The scanning may also be performed in cooperation with the absorber 430 and the substrate 410.

When the absorber 430 scans the substrate 410, the micro light emitting semiconductor devices 100 may be aligned in the wells 420. During wet transfer of the micro light emitting semiconductor devices 100, the micro light emitting semiconductor devices 100 may be aligned due to differences in surface energy between upper surfaces and lower surfaces of the micro light emitting semiconductor devices 100.

Next, a method of manufacturing a micro light emitting semiconductor device, according to another embodiment not forming part of the invention as claimed, is described.

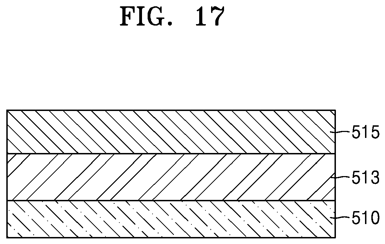

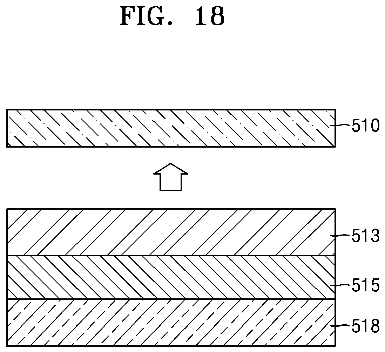

Referring to FIG. 17, a u-GaN layer 513 and an n-GaN layer 515 may be stacked on a substrate 510. The substrate 510 may include a sapphire substrate. Referring to FIG. 18, a structure illustrated in FIG. 17 is turned over such that the substrate 510 is on the structure, and then a temporary substrate 518 may be formed on the n-GaN layer 515. Then, the substrate 510 may be separated from the u-GaN layer 513. The temporary substrate 518 is for supporting the n-GaN layer 515 when substrate 510 is removed.

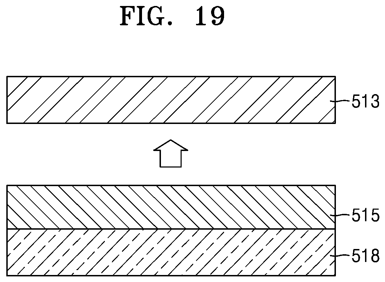

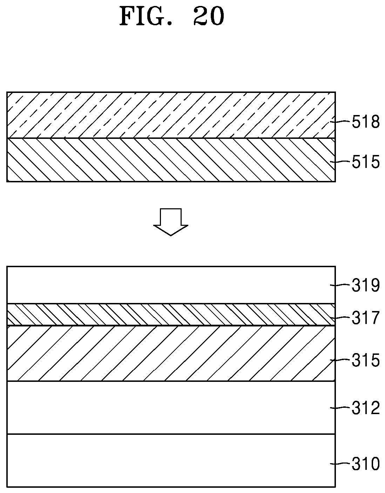

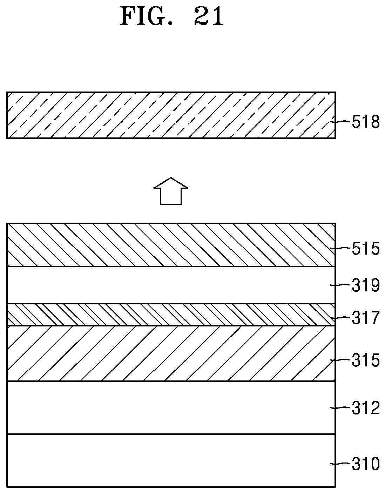

Referring to FIG. 19, the u-GaN layer 513 may be removed from the n-GaN layer 515. Referring to FIG. 20, the n-GaN layer 515 may be coupled to the structure illustrated in FIG. 4 to face the second semiconductor layer 319. Referring to FIG. 21, the temporary substrate 518 may be removed from the n-GaN layer 515 to expose the n-GaN layer 515. the temporary substrate 518 is temporarily coupled to the n-GaN layer 515, and thus, the temporary substrate 518 may be more easily removed therefrom. A color conversion layer may be formed on the n-GaN layer 515 by using the method described above.

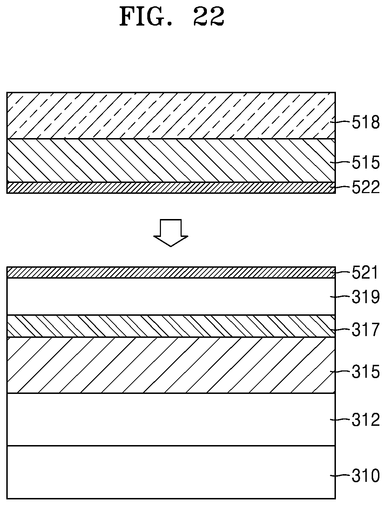

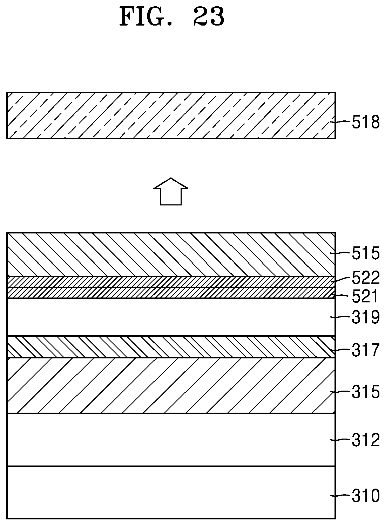

Referring to FIG. 22, in the structure illustrated in FIG. 20, a first interlayer 521 may be formed on the second semiconductor layer 319, and a second interlayer 522 may be formed on the n-GaN layer 515. In addition, referring to FIG. 23, the temporary substrate 518 may be removed to expose the n-GaN layer 515, and a color conversion layer may be formed on the n-GaN layer 515 by using the method described above.

As described above, according to the manufacturing method of the example embodiment, a micro light emitting semiconductor device in which the micro light emitting chip 311 and the color conversion layer 321 are formed in a monolithic structure may be manufactured.

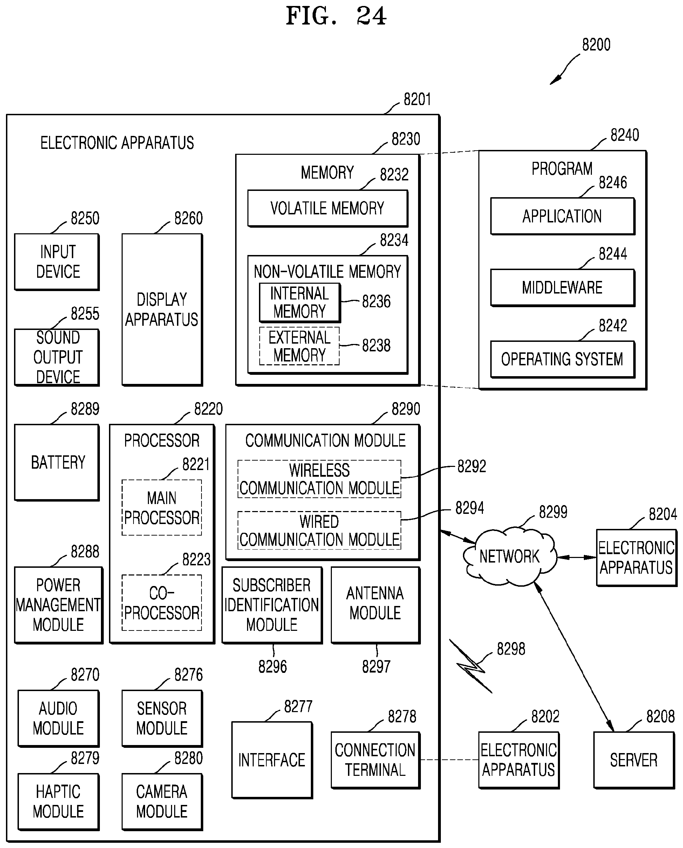

FIG. 24 is a block diagram of an electronic apparatus including a display apparatus according to an example embodiment.

Referring to FIG. 24, an electronic apparatus 8201 may be provided in a network environment 8200. In the network environment 8200, the electronic apparatus 8201 may communicate with another electronic apparatus 8202 through a first network 8298 (a short-range wireless communication network or so on) or may communicate with another electronic apparatus 8204 and/or a server 8208 through a second network 8299 (a long-distance wireless communication network or so on). The electronic apparatus 8201 may communicate with the electronic apparatus 8204 through the server 8208. The electronic apparatus 8201 may include a processor 8220, a memory 8230, an input device 8250, a sound output device 8255, a display apparatus 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. Some of the components may be omitted from the electronic apparatus 8201, or other components may be added to the electronic apparatus 8201. Some of the components may be integrated in one circuit. For example, the sensor module 8276 (a fingerprint sensor, an iris sensor, an illuminance sensor, or so on) may be embedded in the display apparatus 8260 (a display or so on).

The processor 8220 may execute software (such as a program 8240) to control one or a plurality of other components (hardware, software components, and so on) of the electronic apparatus 8201 connected to the processor 8220 and may perform various data processing or arithmetic. The processor 8220 stores commands and/or data received from other components (the sensor module 8276, the communication module 8290, and so on) in a volatile memory 8232 and process the commands and/or the data stored in the volatile memory 8232 and store resulting data in a non-volatile memory 8234 as part of data processing or arithmetic. The non-volatile memory 8234 may include an internal memory 8236 and an external memory 8238. The processor 8220 may include a main processor 8221 (a central processing unit, an application processor, or so on) and a co-processor 8223 (a graphics processing unit, an image signal processor, a sensor hub processor, a communication processor, or so on) that may be operated independently or together therewith. The co-processor 8223 may use less power than the main processor 8221 and may perform a specialized function.

The co-processor 8223 may control functions and/or states related to some components (the display apparatus 8260, the sensor module 8276, the communication module 8290, and so on) of the electronic apparatus 8201 on behalf of the main processor 8221 while the main processor 8221 is in an inactive state (sleep state), or together with the main processor 8221 while the main processor 8221 is in an active state (the application execution state). The co-processor 8223 (an image signal processor, a communication processor, or so on) may be implemented as part of another component (the camera module 8280, the communication module 8290, or so on) functionally related thereto.

The memory 8230 may store a variety of data required by components (the processor 8220, the sensor module 8276, and so on) of the electronic apparatus 8201. Data may include, for example, input data and/or output data for software (such as the program 8240) and commands related thereto. The memory 8230 may include the volatile memory 8232 and/or the non-volatile memory 8234.

The program 8240 may be stored as software in the memory 8230 and may include an operating system 8242, middleware 8244, and/or an application 8246.

The input device 8250 may receive commands and/or data to be used in components (the processor 8220 and so on) of the electronic apparatus 8201 from an exterior (a user or so on) of the electronic apparatus 8201. The input device 8250 may include a remote controller, a microphone, a mouse, a keyboard, and/or a digital pen (a stylus pen or so on).

The sound output device 8255 may output a sound signal to the exterior of the electronic apparatus 8201. The sound output device 8255 may include a speaker and/or a receiver. The speaker may be used for general purposes such as multimedia playback or recording playback, and the receiver may be used to receive incoming calls. The receiver may be integrated into the speaker as part of the speaker or may be implemented as an independent separate device.

The display apparatus 8260 may visually provide information to the exterior of the electronic apparatus 8201. The display apparatus 8260 may include a control circuit for controlling a display, a hologram apparatus, or a projector and a corresponding device. The display apparatus 8260 may include a display apparatus manufactured by using a transfer structure described with reference to FIG. 3. The display apparatus 8260 may include touch circuitry configured to sense a touch, and/or sensor circuitry configured to measure the intensity of force generated by the touch (a pressure sensor or so on).

The audio module 8270 may convert audio into an electrical signal or may convert an electrical signal into audio. The audio module 8270 may acquire audio through the input device 8250 or may output audio through a speaker and/or a headphone of the sound output device 8255, and/or another electronic apparatus (the electronic apparatus 8202) directly or wirelessly connected to the electronic apparatus 8201.

The sensor module 8276 may detect an operation state (power, temperature, and so on) of the electronic apparatus 8201 or an external environmental state (user state or so on) and may generate an electrical signal and/or a data value corresponding to the detected state. The sensor module 8276 may include a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more designated protocols that may be used for the electronic apparatus 8201 to be connected directly or wirelessly to another electronic apparatus (the electronic apparatus 8202 or so on). The interface 8277 may include a high-definition multimedia interface (HDMI), a Universal Serial Bus (USB) interface, a secure digital (SD) card interface, and/or an audio interface.

A connection terminal 8278 may include a connector through which the electronic apparatus 8201 may be physically connected to another electronic apparatus (for example, the electronic apparatus 8202). The connection terminal 8278 may include an HDMI connector, a USB connector, an SD card connector, and/or an audio connector (a headphone connector or so on).

The haptic module 8279 may convert an electrical signal into a mechanical stimulus (vibration, movement, or so on) or an electrical stimulus that a user may perceive through a tactile or motor sense. The haptic module 8279 may include a motor, a piezoelectric effect element, and/or an electrical stimulation element.

The camera module 8280 may capture a still image and a video. The camera module 8280 may include a lens assembly including one or more lenses, image sensors, image signal processors, and/or flashes. The lens assembly included in the camera module 8280 may collect light emitted from a subject to be imaged.

The power management module 8288 may manage power supplied to the electronic apparatus 8201. The power management module 8288 may be implemented as part of a power management integrated circuit (PMIC).

The battery 8289 may supply power to configuration elements of the electronic apparatus 8201. The battery 8289 may include a non-rechargeable primary cell, a rechargeable secondary cell, and/or a fuel cell.

The communication module 8290 may establish a direct (wired) communication channel and/or a wireless communication channel between the electronic apparatus 8201 and another electronic apparatus (the electronic apparatus 8202, the electronic apparatus 8204, the server 8208, or so on), and may support communication through the established communication channel. The communication module 8290 may operate independently of the processor 8220 (application processor or so on) and may include one or more communication processors that support direct communication and/or wireless communication. The communication module 8290 may include a wireless communication module 8292 (a cellular communication module, a short-range wireless communication module, a global navigation satellite system (GNSS) communication module, or so on) and/or a wired communication module 8294 (a Local Area Network (LAN) communication module, a power line communication module, or so on). A corresponding communication module among these communication modules may communicate with another electronic apparatus through the first network 8298 (a short-range communication network such as Bluetooth, WiFi Direct, or infrared data association (IrDA)) or the second network 8299 (a telecommunication network such as a cellular network, the Internet, or a computer network (a LAN, a wide area network (WAN), or so on)). Various types of these communication modules may be integrated into one configuration element (a single chip or so on) or may be implemented as a plurality of separate configuration elements (multiple chips). The wireless communication module 8292 may check and authenticate the electronic apparatus 8201 in a communication network such as the first network 8298 and/or the second network 8299 by using subscriber information (international mobile subscriber identifier (IMSI) and so on) stored in the subscriber identification module 8296.

The antenna module 8297 may transmit a signal and/or power to the outside (other electronic apparatuses or so on) or may receive a signal from the outside. An antenna may include a radiator made of a conductive pattern formed on a substrate (a printed circuit board (PCB) or so on). The antenna module 8297 may include one or a plurality of antennas. When a plurality of antennas are included, an antenna suitable for a communication method used in a communication network such as the first network 8298 and/or the second network 8299 may be selected from among the plurality of antennas by the communication module 8290. A signal and/or power may be transmitted or received between the communication module 8290 and other electronic apparatuses through the selected antenna. In addition to the antenna, other components (a radio frequency integrated circuit (RFIC) and so on) may be included as some of the antenna module 8297.

Some of the configuration elements may be connected to each other through a communication method (a bus, general purpose input and output (GPIO), serial peripheral interface (SPI), mobile industry processor interface (MIPI), or so on) between peripheral devices and may exchange signals (commands, data, and so on).

A command or data may be transmitted or received between the electronic apparatus 8201 and the electronic apparatus 8204, which is external, through the server 8208 connected to the second network 8299. The other electronic apparatuses 8202 and 8204 may be the same apparatuses as or different types of apparatuses from the electronic apparatus 8201. All or some of operations performed by the electronic apparatus 8201 may be performed by one or more of the other electronic apparatuses 8202, 8204, and 8208. For example, when the electronic apparatus 8201 needs to perform a function or service, the electronic apparatus may request one or more other electronic apparatuses to perform the function or part or all of the service, instead of performing the function or service by itself. One or more other electronic apparatuses that receive a request may perform an additional function or service related to the request and may transmit a performance result to the electronic apparatus 8201. To this end, cloud computing technology, distributed computing technology, and/or client-server computing technology may be used.

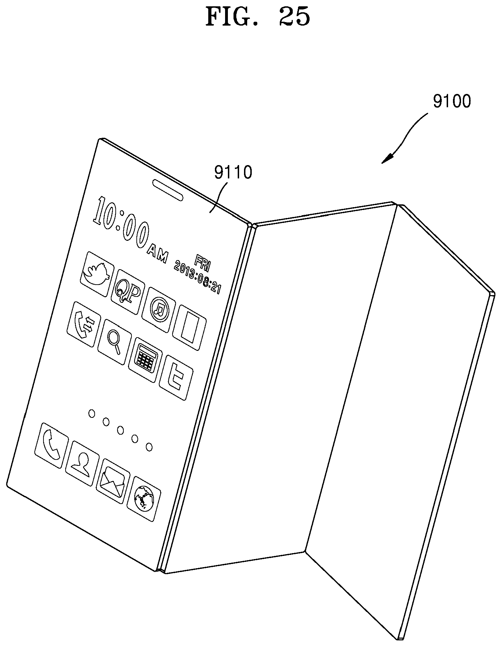

FIG. 25 illustrates an example in which the electronic apparatus according to the example embodiment is applied to a mobile apparatus. A mobile apparatus 9100 may include a display apparatus 9110, and the display apparatus 9110 may include the display apparatuses manufactured by using a transfer structure described with reference to FIG. 3. The display apparatus 9110 may have a foldable structure, for example, a multi-foldable structure.

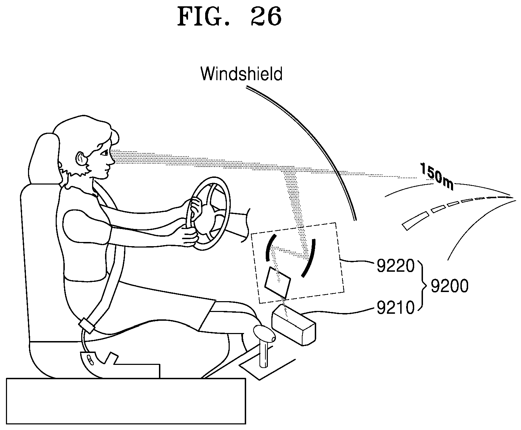

FIG. 26 illustrates an example in which the display apparatus according to the example embodiment is applied to a vehicle. The display apparatus may include a head-up display apparatus 9200 for a vehicle and may include a display 9210 provided in one region of the vehicle and a light path modification member 9220 that converts a light path such that a driver may see an image generated by the display 9210.

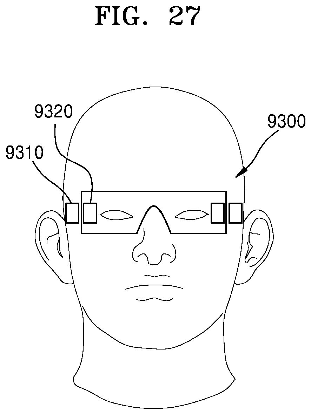

FIG. 27 illustrates an example in which the display apparatus according to the example embodiment is applied to augmented reality glasses or virtual reality glasses. Augmented reality glasses 9300 may include a projection system 9310 that forms an image, and an element 9320 that guides the image from the projection system 9310 into a user's eye. The projection system 9310 may include a display apparatus to which a transfer structure described with reference to FIG. 3 is applied.

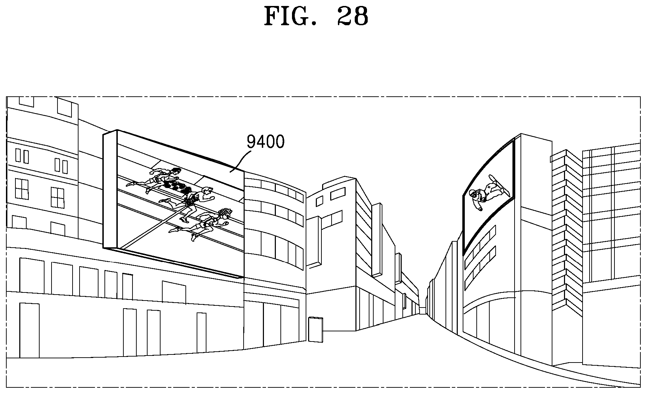

FIG. 28 illustrates an example in which the display apparatus according to the example embodiment is applied to a large-sized signage. A signage 9400 may be used for outdoor advertisements using a digital information display and may control advertisement content and so on through a communication network. The signage 9400 may be implemented through, for example, the electronic apparatus described with reference to FIG. 24.

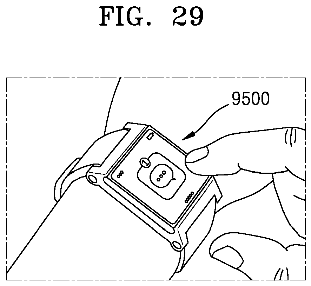

FIG. 29 illustrates an example in which the display apparatus according to the example embodiment is applied to a wearable display. A wearable display 9500 may include a display apparatus manufactured by using a transfer structure described with reference to FIG. 3 and may be implemented by the electronic apparatus described with reference to FIG. 24.

The display apparatus according to the example embodiment may be applied to various products such as a rollable TV and a stretchable display.

According to a micro light emitting semiconductor device of an example embodiment, a micro light emitting chip may be combined with a color conversion layer for color conversion in a monolithic structure. Therefore, a method of manufacturing a micro light emitting semiconductor device may simplify a manufacturing process and reduce manufacturing cost.

It should be understood that example embodiments described herein should be considered in a descriptive sense only and not for purposes of limitation. Descriptions of features or aspects within each example embodiment should typically be considered as available for other similar features or aspects in other embodiments. While example embodiments have been described with reference to the figures, it will be understood by those of ordinary skill in the art that various changes in form and details may be made therein without departing from the scope as defined by the following claims.

## Claims

1. A micro light emitting semiconductor device (100) comprising:
a first semiconductor layer (110);
a light emitting layer (115) provided on the first semiconductor layer;
a second semiconductor layer (120) provided on the light emitting layer; and
a color conversion layer (130) provided on the second semiconductor layer, the color conversion layer comprising a porous layer (131) that comprises quantum dots (132),
**characterised in that**
a doping type of the second semiconductor layer is different from a doping type of the color conversion layer.

2. The micro light emitting semiconductor device of claim 1, wherein the first semiconductor layer includes an n-type semiconductor, and the second semiconductor layer includes a p-type semiconductor.

3. The micro light emitting semiconductor device of claim 1 or 2, wherein the porous layer includes an n-GaN.

4. The micro light emitting semiconductor device of any preceding claim, wherein the first semiconductor layer, the light emitting layer, and the second semiconductor layer are included in a micro light emitting chip, and the color conversion layer is connected to the micro light emitting chip in a monolithic structure.

5. The micro light emitting semiconductor device of any preceding claim, further comprising an interlayer provided between the second semiconductor layer and the color conversion layer.

6. The micro light emitting semiconductor device of claim 5, wherein the interlayer includes one of an oxide including at least one of SiO₂, LiNbO₃, and LiTaO₃, and a metal compound including at least one of Au:Ni, Au:Si, Al:Ge, Au:In, and Au:Sn.

7. The micro light emitting semiconductor device of any preceding claim, further comprising a protective layer provided adjacent to the color conversion layer.

8. The micro light emitting semiconductor device of claim 7, wherein the protective layer extends to the second semiconductor layer and the light emitting layer.

9. The micro light emitting semiconductor device of any preceding claim, further comprising a distributed Bragg reflective layer provided on the color conversion layer.

10. The micro light emitting semiconductor device of any preceding claim, the micro light emitting semiconductor device is a GaN based light emitting device.

11. A display apparatus comprising:
a substrate;
partition walls provided on the substrate and spaced apart from each other; and
a plurality of micro light emitting semiconductor devices each according to any preceding claim respectively provided in wells partitioned by the partition walls.

12. A method of manufacturing a micro light emitting semiconductor device, the method comprising:
forming a first semiconductor layer (315) on a first substrate (310);
forming a light emitting layer (317) on the first semiconductor layer;
forming a second semiconductor layer (319) on the light emitting layer;
stacking a u-GaN layer (323) and an n-GaN layer (327) on a second substrate;
bonding the n-GaN layer to the second semiconductor layer;
separating the u-GaN layer from the n-GaN layer;
forming a porous layer (328) by etching the n-GaN layer through electrochemical etching;
forming a color conversion layer (321) by immersing the porous layer in a quantum dot liquid to infiltrate quantum dots (329) into the porous layer; and
separating a structure formed by the above operations in units of microchips.

13. The method of claim 12, further comprising:
after stacking the u-GaN layer and the n-GaN layer on the second substrate and forming a temporary substrate on the n-GaN layer;
separating the second substrate from the u-GaN layer; and
separating the u-GaN layer from the n-GaN layer.

14. The method of claim 13 further comprising forming an interlayer between the second semiconductor layer and the color conversion layer.

15. The method of claim 13 or 14 further comprising forming a protective layer adjacent to the color conversion layer, and optionally wherein the protective layer extends to the second semiconductor layer and the light emitting layer.

## Patentansprüche

1. Mikrolichtemittierende Halbleitervorrichtung (100), umfassend:
eine erste Halbleiterschicht (110);
eine lichtemittierende Schicht (115), die auf der ersten Halbleiterschicht bereitgestellt ist;
eine zweite Halbleiterschicht (120), die auf der lichtemittierenden Schicht bereitgestellt ist; und
eine Farbumwandlungsschicht (130), die auf der zweiten Halbleiterschicht bereitgestellt ist, wobei die Farbumwandlungsschicht eine poröse Schicht (131) umfasst, die Quantenpunkte (132) umfasst,
**dadurch gekennzeichnet, dass**
sich ein Dotierungstyp der zweiten Halbleiterschicht von einem Dotierungstyp der Farbumwandlungsschicht unterscheidet.

2. Mikrolichtemittierende Halbleitervorrichtung nach Anspruch 1, wobei die erste Halbleiterschicht einen Halbleiter vom n-Typ beinhaltet und die zweite Halbleiterschicht einen Halbleiter vom p-Typ beinhaltet.

3. Mikrolichtemittierende Halbleitervorrichtung nach Anspruch 1 oder 2, wobei die poröse Schicht ein n-GaN beinhaltet.

4. Mikrolichtemittierende Halbleitervorrichtung nach einem vorhergehenden Anspruch, wobei die erste Halbleiterschicht, die lichtemittierende Schicht und die zweite Halbleiterschicht in einem mikrolichtemittierenden Chip enthalten sind und die Farbumwandlungsschicht mit dem mikrolichtemittierenden Chip in einer monolithischen Struktur verbunden ist.

5. Mikrolichtemittierende Halbleitervorrichtung nach einem vorhergehenden Anspruch, ferner umfassend eine Zwischenschicht, die zwischen der zweiten Halbleiterschicht und der Farbumwandlungsschicht bereitgestellt ist.

6. Mikrolichtemittierende Halbleitervorrichtung nach Anspruch 5, wobei die Zwischenschicht eines von einem Oxid, das zumindest eines von SiO₂, LiNbO₃ und LiTaO₃ beinhaltet, und eine Metallverbindung, die zumindest eines von Au:Ni, Au:Si, Al:Ge, Au:In und Au:Sn beinhaltet, beinhaltet.

7. Mikrolichtemittierende Halbleitervorrichtung nach einem vorhergehenden Anspruch, ferner umfassend eine Schutzschicht, die benachbart zu der Farbumwandlungsschicht bereitgestellt ist.

8. Mikrolichtemittierende Halbleitervorrichtung nach Anspruch 7, wobei sich die Schutzschicht zu der zweiten Halbleiterschicht und der lichtemittierenden Schicht erstreckt.

9. Mikrolichtemittierende Halbleitervorrichtung nach einem vorhergehenden Anspruch, ferner umfassend eine verteilte reflektierende Bragg-Schicht, die auf der Farbumwandlungsschicht bereitgestellt ist.

10. Mikrolichtemittierende Halbleitervorrichtung nach einem vorhergehenden Anspruch, wobei die mikrolichtemittierende Halbleitervorrichtung eine auf GaN basierende lichtemittierende Vorrichtung ist.

11. Anzeigeeinrichtung, umfassend:
ein Substrat;
Trennwände, die auf dem Substrat bereitgestellt und voneinander beabstandet sind; und
eine Vielzahl von mikrolichtemittierenden Halbleitervorrichtungen jeweils gemäß einem vorhergehenden Anspruch, die jeweils in Vertiefungen bereitgestellt sind, die durch die Trennwände getrennt sind.

12. Verfahren zur Herstellung einer mikrolichtemittierenden Halbleitervorrichtung, wobei das Verfahren Folgendes umfasst:
Bilden einer ersten Halbleiterschicht (315) auf einem ersten Substrat (310);
Bilden einer lichtemittierenden Schicht (317) auf der ersten Halbleiterschicht;
Bilden einer zweiten Halbleiterschicht (319) auf der lichtemittierenden Schicht;
Stapeln einer u-GaN-Schicht (323) und einer n-GaN-Schicht (327) auf ein zweites Substrat;
Binden der n-GaN-Schicht an die zweite Halbleiterschicht;
Separieren der u-GaN-Schicht von der n-GaN-Schicht;
Bilden einer porösen Schicht (328) durch Ätzen der n-GaN-Schicht durch elektrochemisches Ätzen;
Bilden einer Farbumwandlungsschicht (321) durch Eintauchen der porösen Schicht in eine Quantenpunktflüssigkeit, um Quantenpunkte (329) in die poröse Schicht zu infiltrieren; und
Separieren einer Struktur, die durch die obigen Vorgänge gebildet wird, in Einheiten von Mikrochips.

13. Verfahren nach Anspruch 12, ferner umfassend:
nach dem Stapeln der u-GaN-Schicht und der n-GaN-Schicht auf dem zweiten Substrat und dem Bilden eines temporären Substrats auf der n-GaN-Schicht;
Separieren des zweiten Substrats von der u-GaN-Schicht; und
Separieren der u-GaN-Schicht von der n-GaN-Schicht.

14. Verfahren nach Anspruch 13, ferner umfassend Bilden einer Zwischenschicht zwischen der zweiten Halbleiterschicht und der Farbumwandlungsschicht.

15. Verfahren nach Anspruch 13 oder 14, ferner umfassend Bilden einer Schutzschicht benachbart zu der Farbumwandlungsschicht und wobei sich optional die Schutzschicht zu der zweiten Halbleiterschicht und der lichtemittierenden Schicht erstreckt.

## Revendications

1. Microdispositif à semi-conducteur émetteur de lumière (100), comprenant :
une première couche de semi-conducteur (110) ;
une couche émettrice de lumière (115) disposée sur la première couche de semi-conducteur ;
une seconde couche de semi-conducteur (120) disposée sur la couche émettrice de lumière ; et une couche de conversion de couleur (130) disposée sur la seconde couche de semi-conducteur, la couche de conversion de couleur comprenant une couche poreuse (131) qui comprend des points quantiques (132), **caractérisé en ce qu'**un type de dopage de la seconde couche de semi-conducteur est différent d'un type de dopage de la couche de conversion de couleur.

2. Microdispositif à semi-conducteur émetteur de lumière de la revendication 1, ladite première couche de semi-conducteur comprenant un semi-conducteur de type N, et ladite seconde couche de semi-conducteur comprenant un semi-conducteur de type P.

3. Microdispositif à semi-conducteur émetteur de lumière de la revendication 1 ou 2, ladite couche poreuse comprenant un n-GaN.

4. Microdispositif à semi-conducteur émetteur de lumière d'une quelconque revendication précédente, ladite première couche de semi-conducteur, ladite couche émettrice de lumière et ladite seconde couche de semi-conducteur étant comprises dans une micropuce émettrice de lumière, et ladite couche de conversion de couleur étant connectée à la micropuce émettrice de lumière dans une structure monolithique.

5. Microdispositif à semi-conducteur émetteur de lumière d'une quelconque revendication précédente, comprenant en outre une couche intermédiaire prévue entre la seconde couche semi-conductrice et la couche de conversion de couleur.

6. Microdispositif à semi-conducteur émetteur de lumière de la revendication 5, ladite couche intermédiaire comprenant l'un d'un oxyde comprenant au moins un parmi SiO₂, LiNbO₃ et LiTaO₃, et un composé métallique comprenant au moins un parmi Au:Ni, Au:Si, Al:Ge, Au:In et Au:Sn.

7. Microdispositif à semi-conducteur émetteur de lumière d'une quelconque revendication précédente, comprenant en outre une couche de protection prévue adjacente à la couche de conversion de couleur.

8. Microdispositif à semi-conducteur émetteur de lumière de la revendication 7, ladite couche protectrice s'étendant vers la seconde couche de semi-conducteur et la couche émettrice de lumière.

9. Microdispositif à semi-conducteur émetteur de lumière d'une quelconque revendication précédente, comprenant en outre une couche réfléchissante de Bragg distribuée disposée sur la couche de conversion de couleur.

10. Microdispositif à semi-conducteur émetteur de lumière d'une quelconque revendication précédente, le microdispositif à semi-conducteur émetteur de lumière est un dispositif émetteur de lumière à base de GaN.

11. Appareil d'affichage comprenant :
un substrat ;
des parois de séparation disposées sur le substrat et espacées les unes des autres ; et
une pluralité de microdispositifs à semi-conducteur émetteur de lumière, chacun selon une quelconque revendication précédente, respectivement disposé dans des puits séparés par les parois de séparation.

12. Procédé de fabrication d'un microdispositif à semi-conducteur émetteur de lumière, le procédé comprenant :
la formation d'une première couche à semi-conducteur (315) sur un premier substrat (310) ;
la formation d'une couche d'émission de lumière (317) sur la première couche de semi-conducteur ;
la formation d'une seconde couche de semi-conducteur (319) sur la couche émettrice de lumière ;
l'empilement d'une couche de u-GaN (323) et d'une couche de n-GaN (327) sur un second substrat ;
la liaison de la couche de n-GaN à la seconde couche de semi-conducteur ;
la séparation de la couche u-GaN de la couche n-GaN ;
la formation d'une couche poreuse (328) en gravant la couche de n-GaN par gravure électrochimique ;
la formation d'une couche de conversion de couleur (321) en immergeant la couche poreuse dans un liquide de points quantiques pour infiltrer les points quantiques (329) dans la couche poreuse ; et
la séparation d'une structure formée par les opérations ci-dessus en unités de micropuces.

13. Procédé de la revendication 12, comprenant en outre :
après l'empilement de la couche u-GaN et de la couche n-GaN sur le second substrat et la formation d'un substrat temporaire sur la couche n-GaN ;
la séparation du second substrat de la couche u-GaN ; et
la séparation de la couche u-GaN de la couche n-GaN.

14. Procédé de la revendication 13, comprenant en outre la formation d'une couche intermédiaire entre la seconde couche de semi-conducteur et la couche de conversion de couleur.

15. Procédé de la revendication 13 ou 14 comprenant en outre la formation d'une couche protectrice adjacente à la couche de conversion de couleur, et éventuellement ladite couche protectrice s'étendant vers la seconde couche de semi-conducteur et la couche émettrice de lumière.
